# EUROPEAN PATENT APPLICATION

(11) **EP 4 746 042 A1**
(43) Date of publication of application: **20.05.2026**
(21) Application number: 25175089.9
(22) Date of filing: 08.05.2025
(51) Int. Cl.: H01L 23/498, H01L 23/373

(54) **POWER MODULE, MOTOR CONTROLLER AND VEHICLE**

(30) Priority: 15.11.2024 CN 202411640451
(71) Applicant: Xiaomi EV Technology Co., Ltd., Beijing 100176 (CN)
(72) Inventor: MAO, Sen, Beijing, 100176 (CN); JIN, Yongming, Beijing, 100176 (CN); LAN, Xiang, Beijing, 100176 (CN); LIU, Weixing, Beijing, 100176 (CN)
(74) Representative: Hersina, Günter

(57) **Abstract**

A power module (10) includes a substrate (1) and a power terminal (2), the power terminal (2) is arranged on a side of the substrate (1) in a thickness direction of the substrate (1), an orthographic projection of the power terminal (2) in a direction towards the substrate (1) covers a part of the substrate (1), an end face of the power terminal (2) adjacent to the substrate (1) is electrically connected to the substrate (1), and another end face of the power terminal (2) away from the substrate (1) is configured to be electrically connected to a mating component.

## Description

### FIELD

The present invention relates to the field of motor controllers, and more particularly to a power module, a motor controller and a vehicle.

### BACKGROUND

As the efficiency and power density of a motor controller continue to increase, a maximum operating voltage of a power module of the motor controller gradually is also increasing and the current output capability of the power module is becoming greater, while the volume of the power module is becoming smaller, and the stray inductance of the power module is also becoming smaller. A plastic-encapsulated power module has become a main solution for power module packaging design due to its advantages such as a compact size, a high power density, and a low stray inductance.

### SUMMARY

Accordingly, embodiments of the present invention propose a power module to reduce the overall volume of the power module.

A first aspect of embodiments of the present invention provides a power module, including a substrate and a power terminal. The power terminal is arranged at a side of the substrate in a thickness direction of the substrate, an orthographic projection of the power terminal in a direction towards the substrate covers a part of the substrate, an end face of the power terminal adjacent to the substrate is electrically connected to the substrate, and another end face of the power terminal away from the substrate is configured to be electrically connected to a mating component.

Optionally, the power terminal is a conductive block, and a thickness direction of the conductive block is consistent with the thickness direction of the substrate.

Optionally, a thickness of the conductive block ranges from 2 mm to 5 mm.

Optionally, the power module further includes a plastic package body, the substrate is encapsulated within the plastic package body, and at least a part of the power terminal is encapsulated within the plastic package body.

Optionally, the plastic package body includes a first plastic package portion and a second plastic package portion, the second plastic package portion protrudes from the first plastic package portion in a direction facing away from the substrate, the substrate and a part of the power terminal are encapsulated within the first plastic package portion, and another part of the power terminal is encapsulated within the second plastic package portion.

Optionally, an end face of the power terminal away from the first plastic package portion is flush with an end face of the second plastic package portion away from the first plastic package portion; or an end face of the power terminal away from the first plastic package portion is higher than the end face of the second plastic package portion away from the first plastic package portion.

Optionally, the power terminal includes a first side face and a second side face arranged adjacent to each other, and the first side face intersects with the second side face.

Optionally, the orthographic projection of the power terminal in the direction towards the substrate is a polygon.

Optionally, the power terminal has a prismatic shape.

Optionally, the orthographic projection of the power terminal in the direction towards the substrate is a rectangle, and a ratio of a long side of the rectangle to a short side of the rectangle ranges from 1.5 to 6.5.

Optionally, a side face of the power terminal has a protrusion, and/or a side face of the power terminal has a groove.

Optionally, the protrusion is in an annular shape and arranged around a circumference of the power terminal; and/or the groove is in an annular shape and around the circumference of the power terminal.

Optionally, a plurality of protrusions are provided, and at least two of the plurality of protrusions are arranged at intervals along the thickness direction of the substrate; and/or a plurality of grooves are provided, and at least two of the plurality of grooves are arranged at intervals along the thickness direction of the substrate.

Optionally, the power module further includes a signal terminal, the signal terminal and the power terminal are arranged at the same side of the substrate in the thickness direction of the substrate; an end of the signal terminal adjacent to the substrate is electrically connected to the substrate, and an end of the power terminal away from the substrate is configured to be electrically connected to a chip.

Optionally, the power module further includes a connecting block, the connecting block is arranged between the substrate and the signal terminal in the thickness direction of the substrate, and at least a part of the connecting block is encapsulated within the plastic package body; and the connecting block is a conductive block, an end face of the connecting block adjacent to the substrate is electrically connected to the substrate, and another end face of the connecting block away from the substrate is electrically connected to the signal terminal.

Optionally, the end face of the connecting block away from the substrate is higher than an end face of the plastic package body away from the substrate.

Optionally, the power terminal is welded to the substrate.

Optionally, the material of the power terminal is an alloy.

Optionally, a plurality of power terminals are arranged at intervals around an edge of the substrate.

The present invention further proposes a motor controller.

A second aspect of embodiments of the present invention provides a motor controller, including a power module, a connecting bar, and a mating component. The power module is the power module according to any one of the above embodiments; an end of the connecting bar is electrically connected to the end face of the power terminal away from the substrate, and another end of the connecting bar is electrically connected to the mating component.

Optionally, a plurality of power terminals and a plurality of connecting bars are provided, the plurality of power terminals include an input terminal and an output terminal, and the plurality of connecting bars include an input bar and an output bar; the input bar is electrically connected to the input terminal, and the output bar is electrically connected to the output terminal.

Optionally, a plurality of input terminals and a plurality of input bars are provided, the plurality of input terminals include a first pole terminal and a second pole terminal, the plurality of input bars include a first pole input bar and a second pole input bar, the first pole input bar is electrically connected to the first pole terminal, and the second pole input bar is electrically connected to the second pole terminal; and a part of an orthographic projection of the first pole input bar in the thickness direction of the substrate covers a part of an orthographic projection of the second pole input bar in the thickness direction of the substrate.

Optionally, the first pole input bar includes a first main body portion, a first extension portion, and a second extension portion; the first extension portion and the second extension portion are arranged at the same side of the first main body portion in a first direction and are both electrically connected to the first main body portion, the first extension portion and the second extension portion are arranged at intervals along a second direction, the first direction is perpendicular to the second direction, and both the first direction and the second direction are perpendicular to the thickness direction of the substrate; a plurality of first pole terminals are provided, and the plurality of first pole terminals include a first terminal and a second terminal, the first terminal and the second terminal are arranged at intervals along the second direction, the first extension portion is electrically connected to the first terminal, and the second extension portion is electrically connected to the second terminal.

Optionally, the second pole input bar includes a second main body portion and a third extension portion, the third extension portion is arranged at a side of the second main body portion in the first direction and is electrically connected to the second main body portion, and the third extension portion is electrically connected to the second pole terminal; at least a part of an orthographic projection of the first main body portion in the thickness direction of the substrate covers at least a part of an orthographic projection of the second main body portion in the thickness direction of the substrate.

Optionally, the second main body portion is arranged at a side of the first main body portion away from the substrate in the thickness direction of the substrate; the first extension portion and the second extension portion are bent in a direction towards the substrate, the second pole terminal is arranged between the first terminal and the second terminal in the second direction, and the third extension portion is arranged between the first extension portion and the second extension portion in the second direction.

Optionally, at least one of a surface of the first extension portion facing the substrate and a surface of the second extension portion facing the substrate is flush with a surface of the third extension portion facing the substrate.

Optionally, the input terminal and the output terminal are arranged at two opposite sides of the substrate in a first direction respectively,, and the first direction is perpendicular to the thickness direction of the substrate; and the input bar and the output bar are arranged at the two opposite sides of the substrate in the first direction, respectively.

Optionally, the connecting bar is welded to the power terminal, and/or the connecting bar is welded to the mating component.

The present invention further proposes a vehicle.

A third aspect of embodiments of the present invention provides a vehicle, including a motor controller according to any one of the above embodiments.

### BRIEF DESCRIPTION OF THE DRAWINGS

FIG. 1 is a perspective view of a power module according to an embodiment of the present invention.
FIG. 2 is a partial sectional view of a power module according to an embodiment of the present invention.
FIG. 3 is a perspective view of a power terminal of a power module according to an embodiment of the present invention.
FIG. 4 is a perspective view of a power terminal of a power module according to another embodiment of the present invention.
FIG. 5 is a perspective view of a power terminal of a power module according to yet another embodiment of the present invention.
FIG. 6 is a perspective view of a power terminal of a power module according to still another embodiment of the present invention.
FIG. 7 is a perspective view of a power terminal of a power module according to still another embodiment of the present invention.
FIG. 8 is a perspective view of a power terminal of a power module according to still another embodiment of the present invention.
FIG. 9 is a first front view of a power module and a power copper bar connected with each other according to an embodiment of the present invention.
FIG. 10 is a second front view of a power module and a power copper bar connected with each other according to an embodiment of the present invention.
FIG. 11 is a sectional view taken along A-A in FIG. 10.
FIG. 12 is a sectional view taken along B-B in FIG. 10.
FIG. 13 is an exploded view of a power module and a power copper bar connected with each other according to an embodiment of the present invention.
FIG. 14 is a front view of a power module in the related art.
FIG. 15 is a sectional view taken along C-C in FIG. 14.

### DETAILED DESCRIPTION

Embodiments of the present invention are described in detail below, examples of which are shown in the drawings. The following embodiments described with reference to the drawing are illustrative. It should be understood that the embodiments described are intended to explain the present invention, but not to limit the present invention.

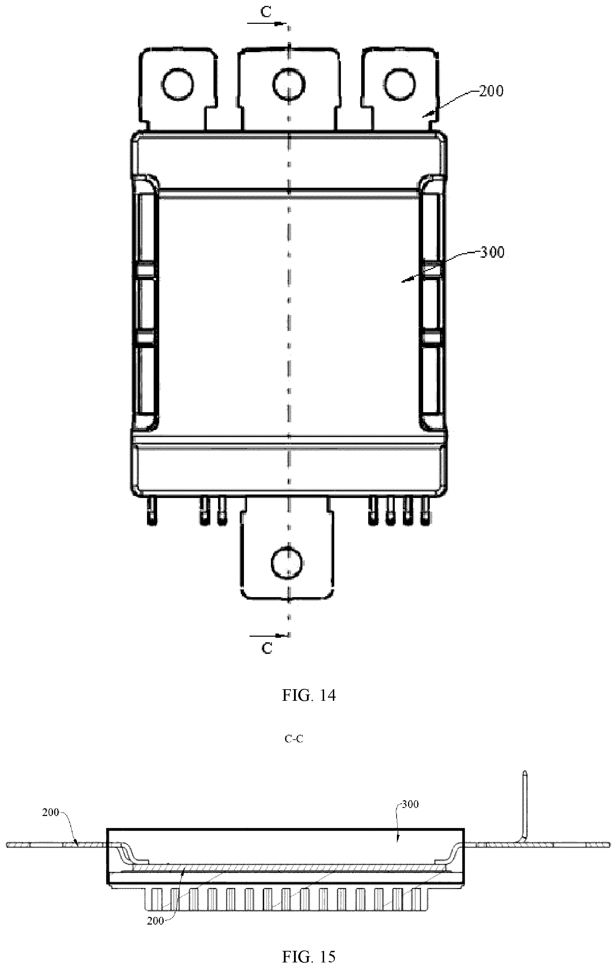

As shown in FIGS. 14 and 15, the power module includes a substrate 100, a power terminal 200, and a plastic package body 300. The substrate 100 is encapsulated within the plastic package body 300; an encapsulated portion of the power terminal 200 is encapsulated within the plastic package body 300 and is electrically connected to the substrate 100, and another encapsulated portion of the power terminal 200 extends outside the plastic package body 300 to be electrically connected to other components. In related art, the power terminal 200 is a power copper bar, and a length direction of the power copper bar is consistent with a length direction or a width direction of the substrate 100; an end of the power copper bar is encapsulated within the plastic package body 300, and another end of the power copper bar extends outside the plastic package body 300, resulting in a longer overall length or width of the power module and thus a larger overall volume of the power module.

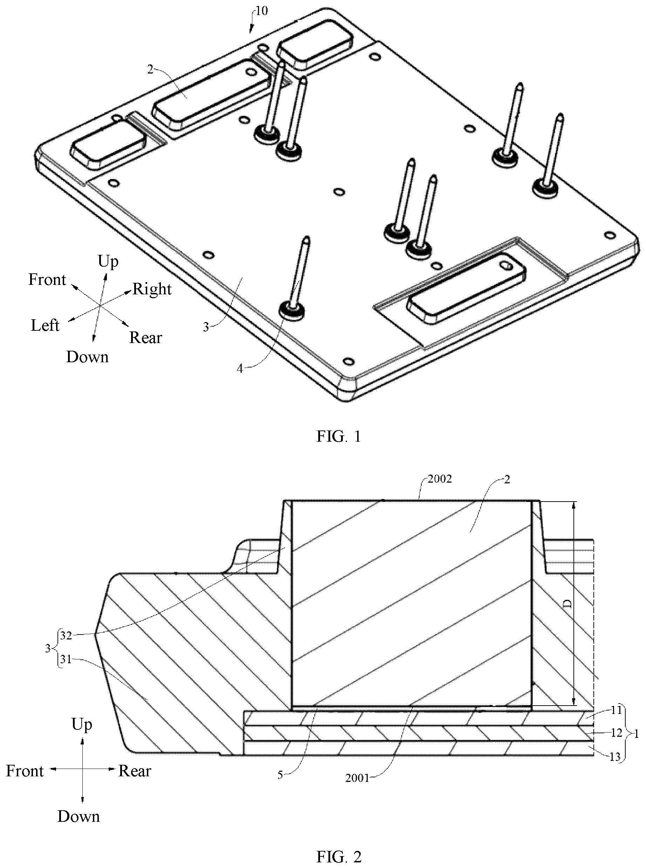

As shown in FIGS. 1 and 2, a power module 10 of an embodiment of the present invention includes a substrate 1 and a power terminal 2. The power terminal 2 is arranged on at one side of the substrate 1 in a thickness direction of the substrate 1, and an orthographic projection of the power terminal 2 in a direction towards the substrate 1 (i.e., in a plane where the substrate 1 is located) covers a part of the substrate 1. An end face of the power terminal 2 adjacent to the substrate 1 is electrically connected to the substrate 1, while another end face of the power terminal 2 away from the substrate 1 (i.e., facing away from the substrate 1) is configured to be electrically connected to a mating component. The mating component may be a capacitor.

The power module 10 of this embodiment of the present invention, by arranging the power terminal 2 at one side of the substrate 1 in the thickness direction of the substrate 1, and covering a part of the substrate 1 with the orthographic projection of the power terminal 2 in the direction towards the substrate 1, may prevent the power terminal 2 from extending outside the substrate 1 in a length direction or a width direction of the substrate 1, thus reducing the length or width of the power module 10 and minimizing the volume of the power module 10.

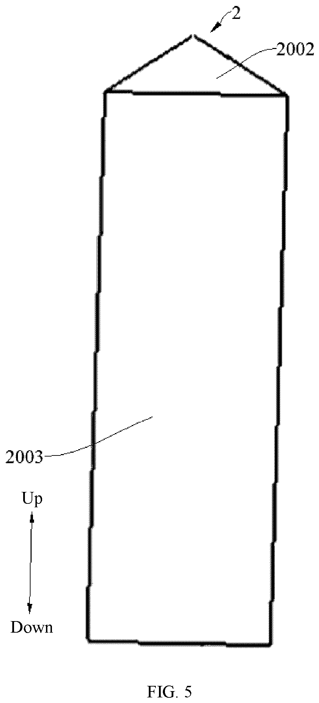

In order to make the technical solution of the present invention easier to understand, the following description takes the thickness direction of the substrate 1 being consistent with an up-down direction as an example to further describe the technical solution of the present invention. The up-down direction is shown in FIGS. 1 to 6.

For example, as shown in FIGS. 1 and 2, the power terminal 2 is arranged at an upper side of the substrate 1, and a downward orthographic projection of the power terminal 2 covers a part of the substrate 1. A lower end face of the power terminal 2 is electrically connected to the substrate 1, and an upper end face of the power terminal 2 is configured to be electrically connected to the mating component.

In some examples, the substrate 1 is a ceramic copper clad laminate.

For example, as shown in FIG. 2, the substrate 1 includes a first copper clad layer 11, a ceramic layer 12, and a second copper clad layer 13. The first copper clad layer 11 is arranged at an upper side of the ceramic layer 12, and the second copper clad layer 13 is arranged at a lower side of the ceramic layer 12. The power terminal 2 is arranged at an upper side of the first copper clad layer 11, and the lower end face of the power terminal 2 is electrically connected to the first copper clad layer 11.

In related art, the power terminal and the mating component are mostly connected by welding, for example, the power terminal and the mating component are laser welded. The power terminal is usually a power copper bar. When the power terminal is welded to the mating component, it is easy to burn through the power terminal, and further burning the power module, thus causing an insulation failure of the power module, and resulting in poor connection reliability between the power module and the mating component.

In some embodiments, the power terminal 2 is a conductive block, and a thickness direction of the conductive block is consistent with the thickness direction of the substrate 1.

By configuring the power terminal 2 as the conductive block, a thickness of the conductive block is relatively large, which may avoid burning through the power terminal 2 when the power terminal 2 is electrically connected to the mating component, thereby avoiding damage to the power module 10 and improving the reliability of the connection between the power module 10 and the mating component.

In some examples, the thickness of the conductive block ranges from 2 mm to 5 mm.

For example, as shown in FIG. 2, a thickness of the conductive block is D, where D is 3mm.

It may be understood that the greater the thickness of the conductive block, the less likely it is to burn through the power terminal 2 when the power terminal 2 is electrically connected to the mating component, and the better the connection reliability between the power module 10 and the mating component. However, a thickness of the power module 10 will also be larger with the thicker conductive block and the cost will be higher. On the other hand, the smaller the thickness of the conductive block, the thickness of the power module 10 will be smaller and the cost will be lower, however, it is easier to burn through the power terminal 2 when the power terminal 2 is electrically connected to the mating component, and the connection reliability between the power module 10 and the mating component is worse.

By setting the thickness of the conductive block ranging from 2 mm to 5 mm, the thickness of the power module 10 may be reduced and the cost of the power module 10 may be lowered, while improving the connection reliability between the power module 10 and the mating component.

In some examples, the power terminal 2 is welded to the substrate 1.

For example, as shown in FIG. 2, the power terminal 2 has a first end face 2001 and a second end face 2002 opposite to each other along the thickness direction of the substrate 1, where the first end face 2001 is the lower end face of the power terminal 2, and the second end face 2002 is the upper end face of the power terminal 2. The first end face 2001 is welded to the substrate 1, and the second end face 2002 is configured to be welded to the mating component. The power terminal 2 may be welded to the substrate 1 through a solder layer 5. The solder layer 5 may be a system soldering tin solder, or a silver paste or a copper paste used for sintering.

The power terminal 2 is welded to the substrate 1, which is beneficial for improving the connection reliability between the power terminal 2 and the substrate 1, and also conducive to enhancing the reliability of the power module 10.

In related art, when using the power copper bar as the power terminal, the entire power terminal is a cantilever structure. Whether the power terminal is connected to the mating component by welding or a screw, due to the existence of assembly tolerances and other factors, the power terminal will be deformed to varying degrees, resulting in a stress concentration problem at an engaging interface between the power terminal and the plastic package body, which, eventually, causes that the cracking problem is prone to occur at the engaging interface between the plastic package body and the power terminal, and the insulation failure problem is prone to occur in the power module.

In some embodiments, as shown in FIGS. 1 and 2, the power module 10 further includes a plastic package body 3, the substrate 1 is encapsulated within the plastic package body 3, and at least a part of the power terminal 2 is encapsulated within the plastic package body 3.

The solution that the at least a part of the power terminal 2 is encapsulated within the plastic package body 3 may be understood as that a part of the power terminal 2 is encapsulated within the plastic package body 3, and another part of the power terminal 2 is located outside the plastic package body 3; or the entire power terminal 2 is encapsulated within the plastic package body 3.

By covering a part of the substrate 1 with the orthographic projection of the power terminal 2 in the direction towards the substrate 1, at least a part of the power terminal 2 is encapsulated within the plastic package body 3, the stress concentration problem at the engaging interface between the power terminal 2 and the plastic package body may be avoided, and the risk of insulation failure in the power module 10 may be reduced. Additionally, the plastic package body 3 may be used to indirectly achieve a mechanical connection between the power terminal 2 and the substrate 1, improving the connection reliability between the power terminal 2 and the substrate 1, and further enhancing the reliability of the power module 10.

In some examples, as shown in FIG. 2, the plastic package body 3 includes a first plastic package portion 31 and a second plastic package portion 32, and the second plastic package portion 32 protrudes from the first plastic package portion 31 in a direction facing away from the substrate 1. The substrate 1 and a part of the power terminal 2 are encapsulated within the first plastic package portion 31, while another part of the power terminal 2 is encapsulated within the second plastic package portion 32.

For example, as shown in FIG. 2, the second plastic package portion 32 protrudes upward from the first plastic package portion 31. The substrate 1 and a lower part of the power terminal 2 are encapsulated within the first plastic package portion 31, and an upper part of the power terminal 2 is encapsulated within the second plastic package portion 32.

It may be understood that the end face of the power terminal 2 away from the substrate 1 will protrude from the substrate 1, therefore, there is a difference in a height of the plastic package body 3 required for the substrate 1 and a height of the plastic package body 3 required for the power terminal 2. By configuring the plastic package body 3 to include the first plastic package portion 31 and the second plastic package portion 32, using the first plastic package portion 31 to achieve a plastic encapsulation of the substrate 1 and a part of the power terminal 2, and using the second plastic package portion 32 to achieve a plastic encapsulation of another part of the power terminal 2, it is possible to achieve a good plastic encapsulation effect of the substrate 1 and the power terminal 2 while avoiding a large overall volume of the plastic package body 3, thus helping to reduce the cost of the power module 10.

In some examples, as shown in FIG. 2, an end face of the power terminal 2 away from the first plastic package portion 31 (i.e., facing away from the first plastic package portion 31) is flush with an end face of the second plastic package portion 32 away from the first plastic package portion 31 (i.e., facing away from the first plastic package portion 31).

For example, the upper end face of the power terminal 2 is flush with an upper end face of the second plastic package portion 32.

By making the end face of the power terminal 2 away from the first plastic package portion 31 flush with the end face of the second plastic package portion 32 away from the first plastic package portion 31, the plastic encapsulation effect of the power terminal 2 may be improved while avoiding the second plastic package portion 32 from affecting the electrical connection between the power terminal 2 and the mating component, thereby improving the reliability of the power module 10.

In other embodiments, the end face of the power terminal 2 away from the first plastic package portion 31 is higher than the end face of the second plastic package portion 32 away from the first plastic package portion 31.

For example, the upper end face of the power terminal 2 is higher than the upper end face of the second plastic package portion 32.

By configuring the end face of the power terminal 2 away from the first plastic package portion 31 to be higher than the end face of the second plastic package portion 32 away from the first plastic package portion 31, it is convenient for the power terminal 2 to be connected to the mating component, thereby facilitating the connection between the power module 10 and the mating component.

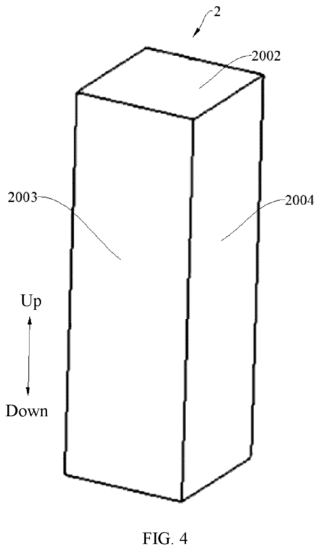

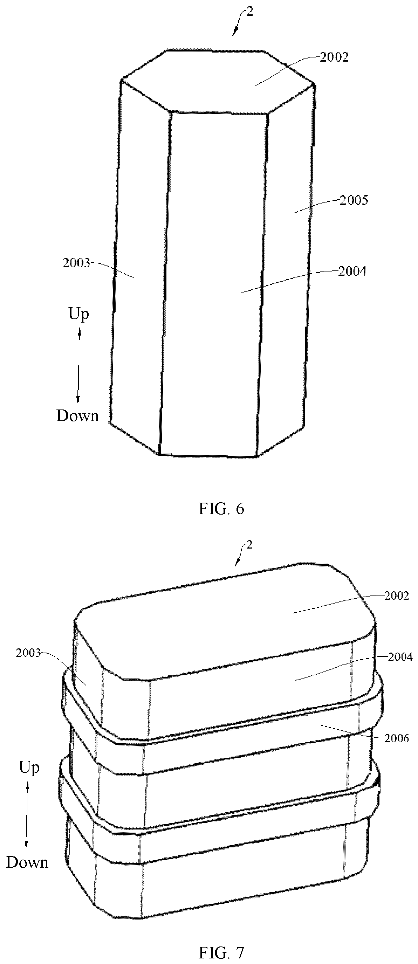

In some examples, as shown in FIGS. 4 and 6, the power terminal 2 includes a first side face 2003 and a second side face 2004 arranged adjacent to each other, and the first side face 2003 intersects with the second side face 2004.

By configuring the first side face 2003 and the second side face 2004 of the power terminal 2 to intersect with each other, a bonding force between the power terminal 2 and the plastic package body 3 may be increased, the connection reliability between the power terminal 2 and the plastic package body 3 may be improved, and furthermore, the reliability of the power module 10 may be enhanced.

In some examples, as shown in FIG. 6, the power terminal 2 further includes a third side face 2005, the second side face 2004 is arranged between the first side face 2003 and the third side face 2005, and the second side face 2004 intersects with the third side face 2005.

By configuring the third side face 2005 of the power terminal 2 to intersect with the second side face 2004, the bonding force between the power terminal 2 and the plastic package body 3 is further increased, and the reliability of the power module 10 is further enhanced.

In some examples, as shown in FIGS. 4 to 8, the orthographic projection of the power terminal 2 in the direction towards the substrate 1 is a polygon.

For example, the orthographic projection of the power terminal 2 in the direction towards the substrate 1 is a triangle, a quadrilateral, a pentagon, a hexagon, etc.

By configuring the orthographic projection in the direction towards the substrate 1 as a polygon, the bonding force between the power terminal 2 and the plastic package body 3 may be further increased, thereby further improving the reliability of the power module 10.

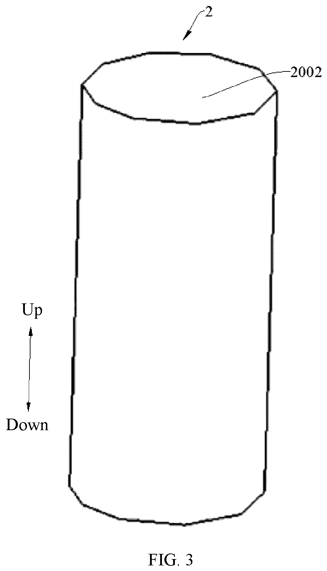

In other embodiments, as shown in FIG. 3, an outer side surface of the power terminal 2 may also be a cylindrical surface. At this point, the orthographic projection of the power terminal 2 in the direction towards the substrate 1 is circular.

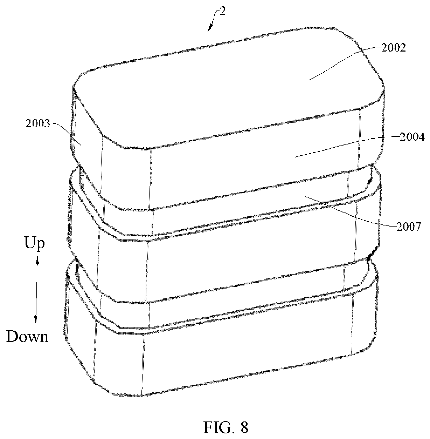

In some examples, as shown in FIGS. 7 and 8, the orthographic projection of the power terminal 2 in the direction towards the substrate 1 is a rectangle, and a ratio of a long side of the rectangle to a short side of the rectangle ranges from 1.5 to 6.5.

For example, as shown in FIGS. 7 and 8, an orthographic projection of the first side face 2003 in the direction towards the substrate 1 is the short side, and an orthographic projection of the second side face 2004 in the direction towards the substrate 1 is the long side; a ratio of the long side to the short side is 4.

Configuring the orthographic projection of the power terminal 2 in the direction towards the substrate 1 as a rectangle facilitates the processing and manufacturing of the power terminal 2. By setting the ratio of the long side of the rectangle to the short side of the rectangle ranging from 1.5 to 6.5, the connection reliability between the power terminal 2 and the mating component may be ensured when the width of the power terminal 2 is relatively small.

In some examples, as shown in FIGS. 4 to 8, the power terminal 2 is in a prismatic shape.

For example, the power terminal 2 is in the prismatic shape such as a square prism, a triangular prism, a hexagonal prism, etc.

Configuring the power terminal 2 in the prismatic shape facilitates the processing and manufacturing of the power terminal 2, and helps to reduce the cost of the power module 10.

In some examples, as shown in FIG. 7, a side face of the power terminal 2 is provided with a protrusion 2006.

By providing the protrusion 2006 on the side face of the power terminal 2, a contact area between the power terminal 2 and the plastic package body 3 may be increased, the bonding force between the power terminal 2 and the plastic package body 3 may be increased, the connection reliability between the power terminal 2 and the plastic package body 3 may be improved, and the reliability of the power module 10 may be enhanced.

In some examples, as shown in FIG. 7, the protrusion 2006 is in an annular shape and arranged around a circumference of the power terminal 2.

For example, as shown in FIG. 7, the protrusion 2006 is an annular boss.

By configuring the protrusion 2006 in the annular shape and arranged around the circumference of the power terminal 2, the bonding force between the power terminal 2 and the plastic package body 3 may be further increased, thereby improving the reliability of the power module 10.

In some examples, as shown in FIG. 7, a plurality of protrusions 2006 are provided, and at least two protrusions 2006 are arranged at intervals along the thickness direction of the substrate 1.

For example, as shown in FIG. 7, the number of protrusions 2006 is two, the two protrusions 2006 are arranged at intervals along the up-down direction, and a groove is defined between the two protrusions 2006.

By arranging the plurality of protrusions 2006 and arranging the at least two protrusions 2006 at intervals along the thickness direction of the substrate 1, the bonding force between the power terminal 2 and the plastic package body 3 may be further increased, thereby improving the reliability of the power module 10.

In some examples, as shown in FIG. 8, a side face of the power terminal 2 has a groove 2007.

By providing the groove 2007 on the side face of the power terminal 2, the contact area between the power terminal 2 and the plastic package body 3 may be increased, the bonding force between the power terminal 2 and the plastic package body 3 may be increased, the connection reliability between the power terminal 2 and the plastic package body 3 may be improved, and the reliability of the power module 10 may be enhanced.

In some examples, as shown in FIG. 8, the groove 2007 is in an annular shape and arranged around a circumference of the power terminal 2.

For example, as shown in FIG. 8, the groove 2007 is an annular groove.

By configuring the groove 2007 in the annular shape and arranged around the circumference of the power terminal 2, the bonding force between the power terminal 2 and the plastic package body 3 may be further increased, thereby improving the reliability of the power module 10.

In some examples, as shown in FIG. 8, a plurality of grooves 2007 are provided, and at least two grooves 2007 are arranged at intervals along the thickness direction of the substrate 1.

For example, as shown in FIG. 8, the number of grooves 2007 is two, the two grooves 2007 are arranged at intervals along the up-down direction, and a boss is defined between the two grooves 2007.

By arranging the plurality of grooves 2007 and arranging the at least two grooves 2007 at intervals along the thickness direction of the substrate 1, the bonding force between the power terminal 2 and the plastic package body 3 may be further increased, thereby improving the reliability of the power module 10.

In related art, the power terminal adopts a power copper bar. The overall structure of the power copper bar is complex, and the power copper bar may be made of only pure copper material, resulting in a large difference in the expansion coefficients between the power terminal and the plastic package body. During the operation of the power module, the power terminal and the plastic package body will undergo repeated high and low temperature changes, which may easily cause cracking problems at the engaging interface between the power terminal and the plastic package body, further leading to an insulation failure of the power module.

In some examples, the material of the power terminal 2 is an alloy.

In some examples, as shown in FIG. 1, a plurality of power terminals 2 are provided, and the plurality of power terminals 2 are arranged at intervals around an edge of the substrate 1.

For example, as shown in FIG. 1, the number of power terminals 2 is four, and the four power terminals 2 are arranged at intervals around the edge of the substrate 1.

By arranging the power terminals 2 around the edge of the substrate 1, it is convenient to connect the power terminal 2 with the mating component, thereby facilitating the connection between the power module 10 and the mating component.

In some examples, the power module 10 further includes a signal terminal 4, and the signal terminal 4 and the power terminal 2 are arranged at the same side of the substrate 1 in the thickness direction of the substrate. An end of the signal terminal 4 adjacent to the substrate 1 is electrically connected to the substrate 1, and an end of the power terminal 2 away from the substrate 1 (i.e., facing away from the substrate 1) is configured to be electrically connected to a chip.

An end of the signal terminal 4 away from the substrate 1 (i.e., facing away from the substrate 1) is configured to be connected with a semiconductor chip (such as an IGBT chip), so as to input a control signal to the semiconductor chip through the signal terminal 4.

For example, as shown in FIG. 1, the signal terminal 4 and the power terminal 2 are arranged at the upper side of the substrate 1.

By arranging the signal terminal 4 and the power terminal 2 on the same side of the substrate 1 in the thickness direction of the substrate 1, it facilitates a wiring operation between the power module 10 and the mating component, as well as a wiring operation between the power module 10 and the chip, thereby improving the installation efficiency of the power module 10.

In some examples, the signal terminal 4 is a signal pin.

For example, the signal terminal 4 is a spring signal pin.

In related art, the electrical connection between the signal terminal and the substrate is achieved by forming a hole in the substrate, inserting the signal terminal into the hole of the substrate and welding the signal terminal to the substrate. Due to a manufacturing tolerances between the signal terminal and the hole in the substrate, there is stress between the signal terminal and the substrate, which may lead to cracking at the engaging interface between the signal terminal and the plastic package body, resulting in insulation failure of the power module.

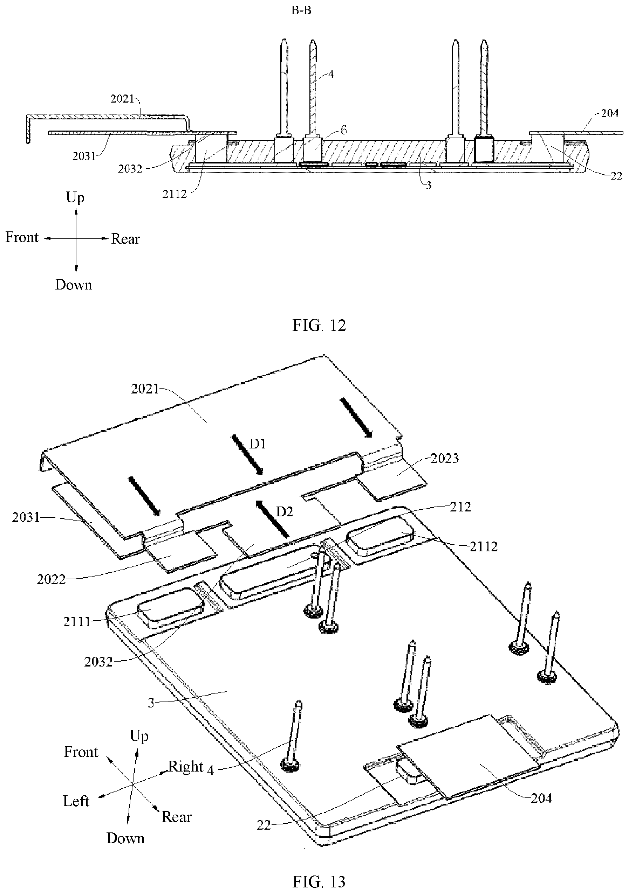

As shown in FIG. 12, the power module 10 further includes a connecting block 6. The connecting block 6 is arranged between the substrate 1 and the signal terminal 4 in the thickness direction of the substrate 1, and at least a part of the connecting block 6 is encapsulated within the plastic package body 3. The connecting block 6 is a conductive block. An end face of the connecting block 6 adjacent to the substrate 1 is electrically connected to the substrate 1, while another end face of the connecting block 6 away from the substrate 1 (i.e., facing away from the substrate 1) is electrically connected to the signal terminal 4.

For example, as shown in FIG. 12, the connecting block 6 is arranged at the upper side of the substrate 1, and the signal terminal 4 is arranged a an upper side of the connecting block 6; a lower end face of the connecting block 6 is electrically connected to the substrate 1, and an upper end face of the connecting block 6 is electrically connected to the signal terminal 4.

By providing the connecting block 6, the signal terminal 4 is electrically connected to the substrate 1 through the connecting block 6, which may avoid forming the hole in the substrate 1, thereby reducing the stress at the engaging interface between the signal terminal 4 and the substrate 1, reducing the risk of cracking in the plastic package body 3, and improving the insulation reliability of the power module 10.

In some examples, as shown in FIG. 12, the end face of the connecting block 6 away from the substrate 1 is higher than an end face of the plastic package body 3 away from the substrate 1 (i.e., facing away from the substrate 1).

For example, as shown in FIG. 12, the upper end face of the connecting block 6 is higher than an upper end face of the plastic package body 3, and the upper end face of the connecting block 6 is electrically connected to the signal terminal 4.

Configuring the end face of the connecting block 6 away from the substrate 1 higher than the end face of the plastic package body 3 away from the substrate 1 facilitates the electrical connection between the signal terminal 4 and the connecting block 6.

In the power module 10 of embodiments of the present invention, due to a simple structure, an easy molding, and a good process ability of the power terminal 2, it allows for more choices for the material of the power terminal 2. For example, a material with an expansion coefficient relatively close to an expansion coefficient of the plastic package body 3, such as a copper molybdenum alloy material, may be used to reduce the risk of cracking at the engaging interface between the power terminal 2 and the plastic package body 3, and to reduce the risk of an insulation failure of the power module 10.

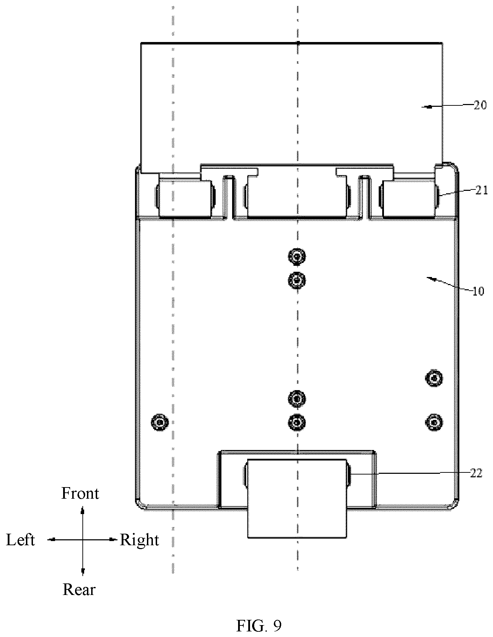

As shown in FIGS. 9 to 13, a motor controller of embodiments of the present invention includes a power module 10, a connecting bar 20, and a mating component. The power module 10 is the power module 10 according to any one of the above embodiments. An end of the connecting bar 20 is electrically connected to the end face of the power terminal 2 away from the substrate 1, and another end of the connecting bar 20 is electrically connected to the mating component. The mating component may be a capacitor.

Since the power module 10 of embodiments of the present invention has a smaller size, the motor controller of embodiments of the present invention has a smaller volume.

In other embodiments, the power module 10 may also be used for other devices of the power module 10 that use a current inversion function, such as a photovoltaic inverter, a high-voltage frequency inverter, etc.

In some examples, the connecting bar 20 is welded to the power terminal 2.

For example, the connecting bar 20 and the power terminal 2 are laser-welded.

Welding the connecting bar 20 to the power terminal 2 may improve the connection reliability between the connecting bar 20 and the power terminal 2, thereby enhancing the connection reliability between the power module 10 and the mating component.

In some examples, the connecting bar 20 is welded to the mating component.

For example, the connecting bar 20 and the mating component are laser-welded.

Welding the connecting bar 20 to the mating component may improve the connection reliability between the connecting bar 20 and the mating component, thereby enhancing the connection reliability between the power module 10 and the mating component.

In some examples, as shown in FIGS. 9 to 13, a plurality of power terminals 2 and a plurality of connecting bars 20 are provided, the power terminals 2 include an input terminal 21 and an output terminal 22, and the connecting bars 20 include an input bar 201 and an output bar 204. The input bar 201 is electrically connected to the input terminal 21, and the output bar 204 is electrically connected to the output terminal 22.

In some examples, as shown in FIGS. 9 to 13, the plurality of input terminals 21 and the plurality of input bars 201 are provided. The input terminals 21 include a first pole terminal 211 and a second pole terminal 212, and the input bars 201 include a first pole input bar 202 and a second pole input bar 203. The first pole input bar 202 is electrically connected to the first pole terminal 211, and the second pole input bar 203 is electrically connected to the second pole terminal 212. A part of an orthographic projection of the first pole input bar 202 in the direction towards the substrate 1 along the thickness direction of the substrate 1 covers a part of an orthographic projection of the second pole input bar 203 in the direction towards the substrate 1 along the thickness direction of the substrate 1.

One of the first pole terminal 211 and the second pole terminal 212 is a positive pole terminal, and the other one of the first pole terminal 211 and the second pole terminal 212 is a negative pole terminal; one of the first pole input bar 202 and the second pole input bar 203 is a positive pole input bar 201, and the other one of the first pole input bar 202 and the second pole input bar 203 is a negative pole input bar 201.

For example, the first pole terminal 211 is the positive pole terminal, the second pole terminal 212 is the negative pole terminal, the first pole input bar 202 is the positive pole input bar, and the second pole input bar 203 is the negative pole input bar. As shown in FIG. 13, a current direction of the first pole input bar 202 and a current direction of the second pole input bar 203 are opposite.

By configuring a part of the orthographic projection of the first pole input bar 202 in the direction towards the substrate 1 along the thickness direction of the substrate 1 to cover a part of the second pole input bar 203 in the direction towards the substrate 1along the thickness direction of the substrate 1, since the current direction of the first pole input bar 202 and the current direction of the second pole input bar 203 are opposite (for example, the current direction of the first pole input bar 202 is shown as an arrow D1 in FIG. 13, and the current direction of the second pole input bar 203 is shown as an arrow D2 in FIG. 13), the stray inductance between the first pole input bar 202 and the second pole input bar 203 may be significantly reduced, and the equivalent series inductance (ESL) of the motor controller may be reduced, thereby enabling the motor controller to operate at higher voltages.

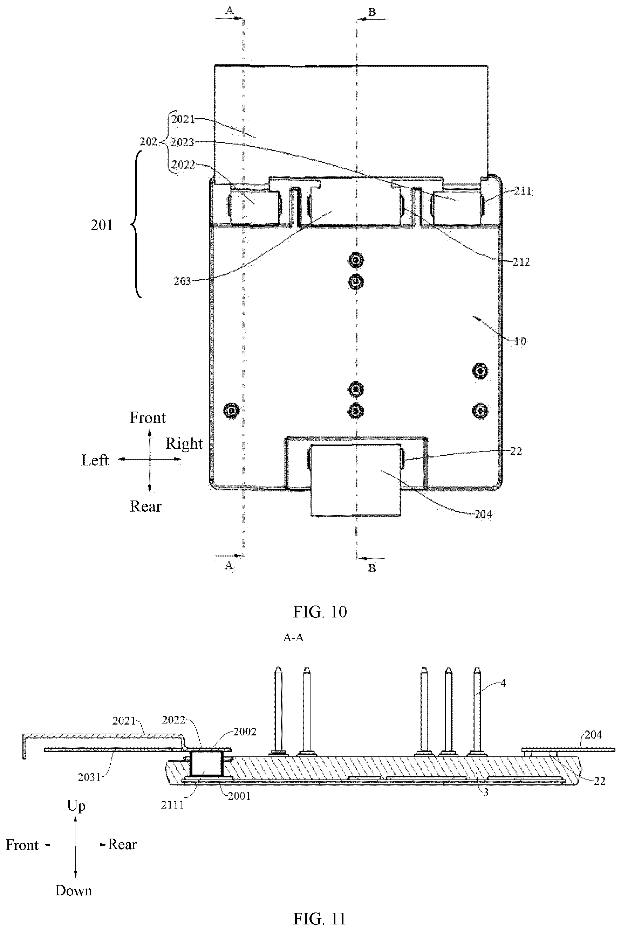

In some examples, as shown in FIGS. 10 and 11, the first pole input bar 202 includes a first main body portion 2021, a first extension portion 2022, and a second extension portion 2023. The first extension portion 2022 and the second extension portion 2023 are arranged at the same side of the first main body portion 2021 in a first direction and are both electrically connected to the first main body portion 2021. A plurality of first pole terminals 211 are provided, and the plurality of first pole terminals 211 include a first terminal 2111 and a second terminal 2112. The first extension portion 2022 and the second extension portion 2023 are arranged at intervals along a second direction, and the first terminal 2111 and the second terminal 2112 are arranged at intervals along the second direction. The first extension portion 2022 is electrically connected to the first terminal 2111, and the second extension portion 2023 is electrically connected to the second terminal 2112. The first direction is perpendicular to the second direction, and both the first direction and the second direction are perpendicular to the thickness direction of the substrate 1.

By configuring the first pole input bar 202 to include the first main body portion 2021, the first extension portion 2022 and the second extension portion 2023, and configuring the first pole terminal 211 to include the first terminal 2111 and the second terminal 2112, the first extension portion 2022 to be electrically connected to the first terminal 2111, and the second extension portion 2023 to be electrically connected to the second terminal 2112, a connection area between the first pole input bar 202 and the power module 10 may be increased, thereby improving the current transmission capability between the power module 10 and the mating component.

In order to make the technical solution of the present invention easier to understand, the following takes the first direction being consistent with a front-rear direction and the second direction being consistent with a left-right direction as an example to further describe the technical solution of the present invention. The front -rear direction is shown in FIG. 1, FIG. 2, and FIGS. 9 to 13. The left-right direction is shown in FIGS. 1, 9, 10, and 13.

For example, the first extension portion 2022 and the second extension portion 2023 are arranged at a rear side of the first main body portion 2021, the first extension portion 2022 is arranged at a left side of the second extension portion 2023, and the first terminal 2111 is arranged at a left side of the second terminal 2112.

In some examples, as shown in FIGS. 12 and 13, the second pole input bar 203 includes a second main body portion 2031 and a third extension portion 2032. The third extension portion 2032 is arranged at a side of the second main body portion 2031 in the first direction and is electrically connected to the second main body portion 2031. The third extension portion 2032 is electrically connected to the second pole terminal 212. At least a part of an orthographic projection of the first main body portion 2021 in the direction towards the substrate 1 along the thickness direction of the substrate 1 covers at least a part of an orthographic projection of the second main body portion 2031 in the direction towards the substrate 1 along the thickness direction of the substrate 1.

That at least a part of the orthographic projection of the first main body portion 2021 in the direction towards the substrate 1 along the thickness direction of the substrate 1 covers at least a part of the orthographic projection of the second main body portion 2031 in the direction towards the substrate 1 along the thickness direction of the substrate 1 may be understood as that a part of the orthographic projection of the first main body portion 2021 in the direction towards the substrate 1 along the thickness direction of the substrate 1 covers a part of the orthographic projection of the second main body portion 2031 in the direction towards the substrate 1 along the thickness direction of the substrate 1, and another part of the orthographic projection of the first main body portion 2021 in the direction towards the substrate 1 along the thickness direction of the substrate 1 covers another part of the orthographic projection of the second main body portion 2031 in the direction towards the substrate 1 along the thickness direction of the substrate 1; or the orthographic projection of the first main body portion 2021 in the direction towards the substrate 1along the thickness direction of the substrate 1 may cover the orthographic projection of the second main body portion 2031 in the direction towards the substrate 1 along the thickness direction of the substrate 1.

For example, as shown in FIGS. 12 and 13, the second extension portion 2023 is arranged at a rear side of the second main body portion 2031. A downward orthographic projection of the first main body portion 2021 covers a downward orthographic projection of the second main body portion 2031.

By configuring at least a part of the orthographic projection of the first main body portion 2021 in the direction towards the substrate 1 along the thickness direction of the substrate 1 to cover at least a part of the orthographic projection of the second main body portion 2031 in the direction towards the substrate 1 along the thickness direction of the substrate 1, the stacked portion between the first pole input bar 202 and the second pole input bar 203 may be improved, the stray inductance between the first pole input bar 202 and the second pole input bar 203 may be effectively reduced, and the equivalent inductance of the motor controller may be reduced, thereby enabling the motor controller to operate at higher voltages.

In some examples, as shown in FIGS. 11 to 13, the second main body portion 2031 is arranged at a side of the first main body portion 2021 adjacent to the substrate 1 in the thickness direction of the substrate 1. The first extension portion 2022 and the second extension portion 2023 are bent in the direction towards the substrate 1. The second pole terminal 212 is arranged between the first terminal 2111 and the second terminal 2112 in the second direction. The third extension portion 2032 is arranged between the first extension portion 2022 and the second extension portion 2023 in the second direction.

For example, the second main body portion 2031 is arranged at a lower side of the first main body portion 2021. The first extension portion 2022 and the second extension portion 2023 are bent downwards. The third extension portion 2032 is arranged between the first extension portion 2022 and the second extension portion 2023 in the left-right direction.

By designing the first extension portion 2022, the second extension portion 2023, and the third extension portion 2032 as described above, the first extension portion 2022, the second extension portion 2023 and the third extension portion 2032 may be arranged more compactly, and the first terminal 2111, the second terminal 2112 and the second pole terminal 212 may be arranged more compactly, further reducing the volume of the motor controller.

In some examples, at least one of a surface of the first extension portion 2022 facing the substrate 1 and a surface of the second extension portion 2023 facing the substrate 1 is flush with a surface of the third extension portion 2032 facing the substrate 1.

For example, a lower surface of the first extension portion 2022, a lower surface of the second extension portion 2023 and a lower surface of the third extension portion 2032 are flush.

By configuring at least one of the surface of the first extension portion 2022 facing the substrate 1 and the surface of the second extension portion 2023 facing the substrate 1 to be flush with the surface of the third extension portion 2032 facing the substrate 1, the volume of the motor controller may be further reduced.

In some examples, a connection area between the second pole terminal 212 and the third extension portion 2032 is larger than a connection area between the first terminal 2111 and the first extension portion 2022. The connection area between the second pole terminal 212 and the third extension portion 2032 is larger than a connection area between the second terminal 2112 and the second extension portion 2023.

For example, the connection area between the second pole terminal 212 and the third extension portion 2032 is S1, the connection area between the first terminal 2111 and the first extension portion 2022 is S2, and the connection area between the second terminal 2112 and the second extension portion 2023 is S3. A sum of S2 and S3 is equal to S1, or the sum of S2 and S3 is greater than S1, or the sum of S2 and S3 is less than S1.

It may be understood that the magnitudes of the currents flowing through the first pole input bar 202 and the second pole input bar 203 are equal, and the current transmission capacities of the first pole input bar 202 and the second pole input bar 203 are similar. By designing the connection area between the second pole terminal 212 and the third extension portion 2032, the connection area between the first terminal 2111 and the first extension portion 2022 and the connection area between the second pole terminal 212 and the third extension portion 2032 as described above, the current transmission capabilities of the first pole input bar 202 and the second pole input bar 203 are made similar.

In some examples, the input terminal 21 and the output terminal 22 are arranged at opposite sides of the substrate 1 in the first direction. The input bar 201 and the output bar 204 are arranged at opposite sides of the substrate 1 in the first direction.

For example, as shown in FIGS. 9 to 13, the input terminal 21 is arranged at a front side of the output terminal 22, and the input bar 201 is arranged at a front side of the output bar 204. The output bar 204 is configured to be directly or indirectly connected with a three-phase input phase line of the motor.

By arranging the input terminal 21 and the output terminal 22 at opposite sides of the substrate 1 in the first direction, and arranging the input bar 201 and the output bar 204 at opposite sides of the substrate 1 in the first direction, a distance between the input bar 201 and the output bar 204 is relatively far, which improves the insulation performance between the input bar 201 and the output bar 204 and enhances the safety of the motor controller.

A vehicle of embodiments of the present invention includes a motor controller according to any one of the above embodiments. For example, the vehicle is an electric vehicle.

In the power module 10, the motor controller, and the vehicle of embodiments of the present invention, the power copper bar in the related art is changed to a conductive block, which greatly reduces the volume of the power module 10. The stacked arrangement of the first pole terminal 211 and the second pole terminal 212 connected to the power terminal 2 greatly reduces the stray inductance of the power module 10 and the motor controller. This solves the problem of plastic encapsulation cracking at the engaging interface between the power terminal 2 and the plastic package body 3, thus reducing the risk of insulation failure of the power module 10 and improving the reliability of the power module 10.

A power module of the present invention, by arranging the power terminal at one side of the substrate in the thickness direction of the substrate, and covering a part of the substrate with an orthographic projection of the power terminal in the direction towards the substrate, may prevent the power terminal from extending outside the substrate in a length direction or a width direction of the substrate, thus reducing the length or width of the power module and thus minimizing the volume of the power module.

In the description of the present invention, it should be understood that the orientation or position relationship indicated by the terms "center", "longitudinal", "transverse", "length", "width", "thickness", "up", "down", "front", "rear", "left", "right", "vertical", "horizontal", "top", "bottom", "inner", "outer", "clockwise", "counterclockwise", "axial", "radial" and "circumferential" and the like, is based on the orientation or position relationship shown in the accompanying drawings, which is only for the convenience of describing the present invention and simplifying the description, and does not indicate or imply that the referred device or element must have a specific orientation, and be constructed and operated in a specific orientation, so it cannot be understood as a limitation of the present invention.

In addition, the terms "first" and "second" are only used for purpose of description, and cannot be understood as indicating or implying relative importance or implicitly indicating the number of indicated technical features. Therefore, the feature defined as "first" or "second" may explicitly or implicitly include at least one such feature. In the description of the present invention, "a plurality of" means at least two, such as two, three, etc., unless otherwise specifically defined.

In the present invention, unless otherwise expressly defined, terms such as "install/mount", "interconnect", "connect", "fix" shall be understood broadly, and may be, for example, fixed connections, detachable connections, or integral connections; may also be mechanical or electrical connections or intercommunication; may also be direct connections or indirect connections via intervening media; may also be inner communications or interactions of two elements, unless otherwise specifically defined. For those skilled in the art, the specific meaning of the above terms in the present invention can be understood according to the specific situations.

In the present invention, unless otherwise expressly defined, the first feature "below", "under", "on bottom of", "above", "on", or "on top of" a second feature may include an embodiment in which the first feature is in direct contact with the second feature, or the first feature is in indirect contact with the second feature through an intermediate media. And, the first feature "above", "on", or "on top of" a second feature may include an embodiment in which the first feature is right or obliquely "above", "on", or "on top of" the second feature, or just means that the first feature is at a height higher than that of the second feature. A first feature "below", "under", or "on bottom of" a second feature may include an embodiment in which the first feature is right or obliquely "below", "under", or "on bottom of" the second feature, or just means that the first feature is at a height lower than that of the second feature.

In the description of the present invention, terms such as "an embodiment", "some embodiments", "an example", "a specific example" or "some examples" means that a particular feature, structure, material, or characteristic described in connection with the embodiment or example is included in at least one embodiment or example of the present invention. Thus, the appearances of these terms in various places throughout this specification are not necessarily referring to the same embodiment or example of the present invention. Furthermore, the particular features, structures, materials, or characteristics may be combined in any suitable manner in one or more embodiments or examples. In addition, without contradiction, those skilled in the art may combine and unite different embodiments or examples or features of the different embodiments or examples described in this specification.

## Claims

1. A power module (10), comprising:
a substrate (1); and
a power terminal (2) arranged at a side of the substrate (1) in a thickness direction of the substrate (1), wherein an orthographic projection of the power terminal (2) in a direction towards the substrate (1) covers a part of the substrate (1), an end face of the power terminal (2) adjacent to the substrate (1) is electrically connected to the substrate (1), and an end face of the power terminal (2) away from the substrate (1) is configured to be electrically connected to a mating component.

2. The power module (10) according to claim 1, wherein the power terminal (2) is a conductive block, and a thickness direction of the conductive block is consistent with the thickness direction of the substrate (1).

3. The power module (10) according to claim 2, wherein a thickness of the conductive block ranges from 2 mm to 5 mm.

4. The power module (10) according to claim 1, further comprising a plastic package body (3), wherein the substrate (1) is encapsulated within the plastic package body (3), and at least a part of the power terminal (2) is encapsulated within the plastic package body (3).

5. The power module (10) according to claim 4, wherein the plastic package body (3) comprises a first plastic package portion (31) and a second plastic package portion (32), the second plastic package portion (32) protrudes from the first plastic package portion (31) in a direction facing away from the substrate (1), the substrate (1) and a part of the power terminal (2) are encapsulated within the first plastic package portion (31), and another part of the power terminal (2) is encapsulated within the second plastic package portion (32).

6. The power module (10) according to claim 5, wherein an end face of the power terminal (2) away from the first plastic package portion (31) is flush with an end face of the second plastic package portion (32) away from the first plastic package portion (31); or an end face of the power terminal (2) away from the first plastic package portion (31) is higher than an end face of the second plastic package portion (32) away from the first plastic package portion (31).

7. The power module (10) according to claim 4, wherein the power terminal (2) comprises a first side face (2003) and a second side face (2004) arranged adjacent to each other, and the first side face (2003) intersects with the second side face (2004);
optionally, the orthographic projection of the power terminal (2) in the direction towards the substrate (1) is a polygon;
optionally, the power terminal (2) has a prismatic shape;
optionally, the orthographic projection of the power terminal (2) in the direction towards the substrate (1) is a rectangle, and a ratio of a long side of the rectangle to a short side of the rectangle ranges from 1.5 to 6.5.

8. The power module (10) according to claim 4, wherein a side face of the power terminal (2) has a protrusion (2006), and/or a side face of the power terminal has a groove (2007);
optionally, the protrusion (2006) is in an annular shape and arranged around a circumference of the power terminal (2); and/or the groove (2007) is in an annular shape and around a circumference of the power terminal (2);
optionally, a plurality of protrusions (2006) are provided, and at least two of the plurality of protrusions (2006) are arranged at intervals along the thickness direction of the substrate (1); and/or a plurality of grooves (2007) are provided, and at least two of the plurality of grooves (2007) are arranged at intervals along the thickness direction of the substrate (1).

9. The power module (10) according to any one of claims 4 to 8, further comprising a signal terminal (4), wherein the signal terminal (4) and the power terminal (2) are arranged at the same side of the substrate (1) in the thickness direction of the substrate (1); and
an end of the signal terminal (4) adjacent to the substrate (1) is electrically connected to the substrate (1), and an end of the power terminal away from the substrate (1) is configured to be electrically connected to a chip;
optionally, the power module (10) further comprising a connecting block (6), wherein the connecting block (6) is arranged between the substrate (1) and the signal terminal (4) in the thickness direction of the substrate (1), and at least a part of the connecting block (6) is encapsulated within the plastic package body (3); and the connecting block (6) is a conductive block, an end face of the connecting block (6) adjacent to the substrate (1) is electrically connected to the substrate (1), and an end face of the connecting block (6) away from the substrate (1) is electrically connected to the signal terminal (4); optionally, the end face of the connecting block (6) away from the substrate (1) is higher than an end face of the plastic package body (3) away from the substrate (1).

10. A motor controller, comprising:
the power module (10) according to any one of claims 1 to 9;
a connecting bar (20), an end of the connecting bar (20) being electrically connected to the end face of the power terminal (2) away from the substrate (1); and
a mating component electrically connected to another end of the connecting bar (20).

11. The motor controller according to claim 10, wherein a plurality of power terminals (2) and a plurality of connecting bars (20) are provided, the plurality of power terminals (2) comprise an input terminal (21) and an output terminal (22), and the plurality of connecting bars (20) comprise an input bar (201) and an output bar (204); and
the input bar (201) is electrically connected to the input terminal (21), and the output bar (204) is electrically connected to the output terminal (22).

12. The motor controller according to claim 11, wherein a plurality of input terminals (21) and a plurality of input bars (201) are provided, the plurality of input terminals (21) comprise a first pole terminal (211) and a second pole terminal (212), the plurality of input bars (201) comprise a first pole input bar (202) and a second pole input bar (203), the first pole input bar (202) is electrically connected to the first pole terminal (211), and the second pole input bar (203) is electrically connected to the second pole terminal (212), and wherein a part of an orthographic projection of the first pole input bar (202) in the direction towards the substrate (1) covers a part of an orthographic projection of the second pole input bar (203) in the direction towards the substrate (1);
optionally, wherein the first pole input bar (202) comprises a first main body portion (2021), a first extension portion (2022), and a second extension portion (2023), the first extension portion (2022) and the second extension portion (2023) are arranged at the same side of the first main body portion (2021) in a first direction and are both electrically connected to the first main body portion (2021), the first extension portion (2022) and the second extension portion (2023) are arranged at intervals along a second direction, the first direction is perpendicular to the second direction, and both the first direction and the second direction are perpendicular to the thickness direction of the substrate (1); and a plurality of first pole terminals (211) are provided, the plurality of first pole terminals (211) comprise a first terminal (2111) and a second terminal (2112), the first terminal (2111) and the second terminal (2112) are arranged at intervals along the second direction, the first extension portion (2022) is electrically connected to the first terminal (2111), and the second extension portion (2023) is electrically connected to the second terminal (2112).

13. The motor controller according to claim 12, wherein the second pole input bar (203) comprises a second main body portion (2031) and a third extension portion (2032), the third extension portion (2032) is arranged at a side of the second main body portion (2031) in the first direction and is electrically connected to the second main body portion (2031), and the third extension portion (2032) is electrically connected to the second pole terminal (212); and at least a part of an orthographic projection of the first main body portion (2021) in the direction towards the substrate (1) covers at least a part of an orthographic projection of the second main body portion (2031) in the direction towards the substrate (1);
optionally, the second main body portion (2031) is arranged at a side of the first main body portion (2021) adjacent to the substrate (1) in the thickness direction of the substrate (1); and the first extension portion (2022) and the second extension portion (2023) are bent in a direction towards the substrate (1), the second pole terminal (212) is arranged between the first terminal (2111) and the second terminal (2112) in the second direction, and the third extension portion (2032) is arranged between the first extension portion (2022) and the second extension portion (2023) in the second direction;
optionally, at least one of a surface of the first extension portion (2022) facing the substrate (1) and a surface of the second extension portion (2023) facing the substrate (1) is flush with a surface of the third extension portion (2032) facing the substrate (1).

14. The motor controller according to any one of claims 11 to 13, wherein the input terminal (21) and the output terminal (22) are arranged at two opposite sides of the substrate (1) in a first direction, respectively, and the first direction is perpendicular to the thickness direction of the substrate (1); and the input bar (201) and the output bar (204) are arranged at the two opposite sides of the substrate (1) in the first direction, respectively.

15. A vehicle, comprising the motor controller according to any one of claims 10 to 14.
